# EUROPEAN PATENT SPECIFICATION

(11) **EP 2 903 407 B1**
(45) Date of publication and mention of the grant of the patent: **04.08.2021**
(21) Application number: 12885734.9
(22) Date of filing: 28.09.2012
(51) Int. Cl.: H05K 13/04, H02K 41/03, H02J 50/80

(54) **DRIVE DEVICE**
ANTRIEBSVORRICHTUNG
DISPOSITIF D'ENTRAÎNEMENT

(43) Date of publication of application: 05.08.2015
(73) Proprietor: FUJI Corporation, Chiryu Aichi (JP)
(72) Inventor: JINDO, Takahiro, Chiryu Aichi (JP); NOMURA, Takeshi, Chiryu Aichi (JP); NAGASAKA, Nobuo, Chiryu Aichi (JP); HIROTA, Shigemoto, Chiryu Aichi (JP); ISHIURA, Naomichi, Chiryu Aichi (JP); TAKIKAWA, Shinji, Chiryu Aichi (JP); IMADERA, Yasuaki, Chiryu Aichi (JP)
(74) Representative: Grünecker Patent- und Rechtsanwälte PartG mbB
(86) International application number: PCT/JP2012/075024
(87) International publication number: WO 2014/049815

(56) References cited:
- EP-A2- 2 375 568
- WO-A2-2011/156768
- JP-A- 2003 045 732
- JP-A- 2006 320 855
- JP-A- 2007 216 155
- JP-A- 2007 326 064
- JP-A- 2007 326 064
- JP-A- 2009 089 520
- US-A- 5 379 514
- None

## Description

### Technical Field

A technique disclosed in this specification relates to a drive device that drives a movable unit by a single shaft or a plurality of shafts. More particularly, the technique disclosed in this specification relates to a drive device that is provided in a substrate work machine. The substrate work machine, which is mentioned here, is for performing predetermined work on a substrate, and includes, for example, a solder printing machine that applies solder paste to a circuit substrate, a mounting machine (which is called a surface mount machine or a chip mounter) that mounts an electronic component on a circuit substrate, a substrate inspection machine that inspects a circuit substrate on which an electronic component is mounted, and the like.

### Background Art

A substrate work machine is provided with a drive device that drives a movable unit by a single shaft or a plurality of shafts. For example, a mounting machine, which is one example of the substrate work machine, includes a drive device for driving a movable unit, on which functional units, such as a suction nozzle and a mark camera, are mounted, on an X-Y plane. As this kind of drive device, there are many drive devices that supply power to a movable unit and perform signal communication with the movable unit by using a power supply cable and a communication cable. However, these deformable cables have problems in terms of disconnection and an increase in space occupied. Accordingly, a technique, which uses means instead of a communication cable, is being developed, and one example of the technique is disclosed in JP-A-6-164192 and JP-A-10-261996. Also, JP-A-2003-45732 and JP-A-2007-326064 each disclose drive devices according to the preamble of independent claim 1.

### Summary of Invention

### Technical Problem

In JP-A-6-164192 and JP-A-10-261996, communication with the movable unit is performed wirelessly but a power supply cable is used to supply power. For this reason, problems still remain in terms of disconnection and an increase in space occupied. An object of a technique disclosed in this specification is to solve problems in terms of disconnection and an increase in space occupied.

### Solution to Problem

A solution to the problem is provided with a drive device according to independent claim 1. Further advantageous effects can be attained with preferred embodiments set out in the dependent claims.

An embodiment of a drive device disclosed in this specification includes a fixed section, a first communication unit that is provided in the fixed section, a first movable unit that is adapted to be movable relative to the fixed section in a first direction, a second communication unit that is provided in the first movable unit and is adapted to wirelessly communicate with the first communication unit, and a non-contact power supply unit that supplies power to a power receiving unit provided in the first movable unit from a power transmission unit provided in the fixed section in a non-contact manner.

In the drive device disclosed in this specification, both power supply and signal communication between the fixed section and the first movable unit are performed wirelessly. For this reason, in the drive device disclosed in this specification, the disconnection of a cable does not occur and space saving is also achieved.

### Brief Description of Drawings

[Fig. 1] Fig. 1 is a perspective view of a mounting machine.
[Fig. 2] Fig. 2 is a perspective view of a component transfer device that is provided in the mounting machine.
[Fig. 3] Fig. 3 is a perspective view of main parts of a Y-axis movable unit.
[Fig. 4] Fig. 4 is a perspective view of the main parts of the Y-axis movable unit that is seen obliquely from below.
[Fig. 5] Fig. 5 is a side view of the component transfer device provided in the mounting machine that is seen in a Y-axis direction.
[Fig. 6] Fig. 6 is a circuit diagram of a non-contact power supply unit.
[Fig. 7] Fig. 7 shows contents of data types that are subjected to multiplex communication.
[Fig. 8] Fig. 8 is a block diagram of an error setting device on a transmitting side.
[Fig. 9] Fig. 9 is a block diagram of an error checking device on a receiving side.
[Fig. 10] Fig. 10 shows an example of a multiplexed data column.

### Description of Embodiments

Features of embodiments of the invention are described below. Meanwhile, each item to be described below independently has technical usability.

The embodiment is a drive device that includes a fixed section, a first communication unit that is provided in the fixed section, a first movable unit that is adapted to be movable relative to the fixed section in a first direction, a second communication unit that is provided in the first movable unit and is adapted to wirelessly communicate with the first communication unit, and a non-contact power supply unit that supplies power to a power receiving unit provided in the first movable unit from a power transmission unit provided in the fixed section in a non-contact manner. A drive mechanism, which drives the first movable unit in the first direction, is not particularly limited. The drive mechanism, which drives the first movable unit, includes a drive mechanism that uses a linear motor or a ball screw in one example. The first communication unit and the second communication unit may perform one-way communication and may perform two-way communication. A power transmission method used in the non-contact power supply unit is an electric field coupling method.

In the drive device, the power transmission unit of the non-contact power supply unit includes a pair of power transmission electrodes, an inductor that is electrically connected to the pair of power transmission electrodes, and an AC power supply that supplies AC power to the pair of power transmission electrodes. In addition, the power receiving unit of the non-contact power supply unit includes a pair of power receiving electrodes that face the pair of power transmission electrodes, respectively. The non-contact power transmission device of this aspect can supply power by using the electric field coupling method.

In the drive device, the first communication unit is a first optical wireless communication unit, and the second communication unit is a second optical wireless communication unit. An optical axis of an optical signal between the first optical wireless communication unit and the second optical wireless communication unit is parallel to the first direction. In this drive device, the first movable unit moves along the optical axis of the optical signal between the first optical wireless communication unit and the second optical wireless communication unit. Accordingly, communication between the first optical wireless communication unit and the second optical wireless communication unit is stable.

The drive device includes a second movable unit, a third optical wireless communication unit, and a fourth optical wireless communication unit. The second movable unit is provided in the first movable unit and is adapted to be movable relative to the first movable unit in a second direction different from the first direction. The third optical wireless communication unit is provided in the first movable unit and is connected to the second optical wireless communication unit. The fourth optical wireless communication unit is provided in the second movable unit. An optical axis of an optical signal between the third optical wireless communication unit and the fourth optical wireless communication unit is parallel to the second direction. In this drive device, the second movable unit moves along the optical axis of the optical signal between the third optical wireless communication unit and the fourth optical wireless communication unit. Accordingly, communication between the third optical wireless communication unit and the fourth optical wireless communication unit is stable. Further, the first movable unit is provided with the second optical wireless communication unit and the third optical wireless communication unit, and an optical signal is converted into an electrical signal between the second optical wireless communication unit and the third optical wireless communication unit. For this reason, electrical signals, which are required for functional units provided in the first movable unit, can be supplied.

The drive device includes a second movable unit and may include a motor, and a controller. The second movable unit is provided in the first movable unit and is adapted to be movable relative to the first movable unit in a second direction different from the first direction. The motor is provided in the first movable unit and drives the second movable unit. The controller is provided in the first movable unit and controls the motor. In this case, the controller drives the motor on the basis of a command signal that is transmitted to the second communication unit from the first communication unit. The controller, which controls the motor by a wireless technique using the first communication unit and the second communication unit, can also be provided in the first movable unit.

In the drive device, the first communication unit and the second communication unit are be adapted to multiplex a plurality of pieces of data and to communicate with each other. Since the movable unit is provided with various functional units, signals transmitted to the functional units provided in the movable unit and/or signals received from the functional units are also various.
It is possible to stably perform the communication of a plurality of kinds of these signals at high speed by using a multiplex communication technique.

### Embodiment

A mounting machine, which is used when an integrated circuit is formed on a circuit substrate, will be described with reference to the drawings. The integrated circuit to be formed on the circuit substrate is formed while being conveyed to a solder printing machine, a mounting machine, and a reflow furnace in this order. The solder printing machine applies solder paste to a mounting position for an electronic component on the circuit substrate. The mounting machine mounts an electronic component at the mounting position on the circuit substrate to which the solder paste has been applied. The reflow furnace solders the electronic component onto the circuit substrate by performing heat treatment on the circuit substrate.

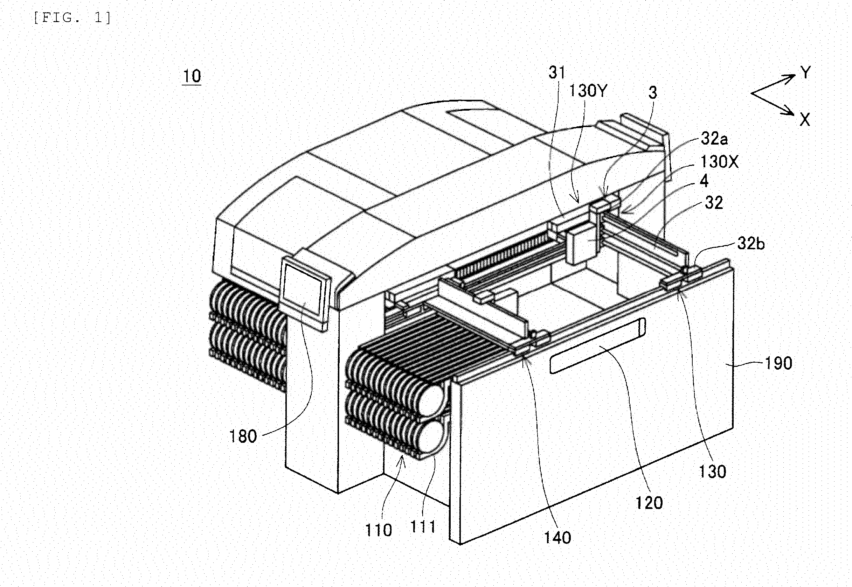

As shown in Fig. 1, a mounting machine 10 includes two modules that are disposed adjacent to each other, and the respective modules have a common structure. Fig. 1 shows a state in which an outer casing of one module of the two modules is removed. Each of the modules includes a component supply device 110, a substrate conveying device 120, two component transfer devices 130 and 140, and an input-output device 180. The input-output device 180 is adapted to be capable of receiving an input from an operator and displaying status information of the module and various instruction signals to be provided to the operator. The module is formed so that these devices are assembled to a machine base 190.

The component supply device 110 is a device that supplies a plurality of kinds of electronic components to be mounted on a circuit substrate to component suction positions, and has a structure in which a plurality of cassette-type feeders 111 are provided in parallel. The feeders 111 are detachably mounted on the machine base 190. The feeder 111 feeds a carrier tape, on which electronic components are attached, at a predetermined pitch to sequentially supply the electronic components to the component suction positions.

The substrate conveying device 120 is fixed to the machine base 190, and conveys a circuit substrate in a conveying direction (X-axis direction) and positions the circuit substrate at a predetermined work position. The substrate conveying device 120 is a double conveyor-type device in which two conveying units (not shown) are provided in parallel.

The two component transfer devices 130 and 140 have a common structure, and are XY robot-type devices that can move in the X-axis direction and the Y-axis direction. The two component transfer devices 130 and 140 are provided so as to correspond to the two conveying units of the substrate conveying device 120, respectively. The component transfer device 130 will be described below, and the description of the component transfer device 140 will be omitted.

As shown in Fig. 1, the component transfer device 130 includes a Y-axis drive device 130Y including a Y-axis movable unit 3 and an X-axis drive device 130X including an X-axis movable unit 4. The Y-axis drive device 130Y includes a linear motor mechanism (to be described below), and is adapted to be capable of moving the Y-axis movable unit 3 relative to the machine base 190 in the Y-axis direction. The Y-axis movable unit 3 corresponds to an example of a first movable unit described in claims. Some elements of the linear motor mechanism are used for both the component transfer devices 130 and 140. The X-axis drive device 130X includes a ball screw feed mechanism (to be described below), and is adapted to be capable of moving the X-axis movable unit 4 relative to the Y-axis drive device 130Y in the X-axis direction. The X-axis movable unit 4 corresponds to an example of a second movable unit described in claims. As described above, the component transfer device 130 is adapted to be capable of driving the X-axis movable unit 4 on an X-Y plane by using the Y-axis drive device 130Y and the X-axis drive device 130X.

The Y-axis movable unit 3 includes a movable body 31 and a slide member 32. The movable body 31 is an element of the linear motor mechanism to be described below, and is adapted to be slidable in the Y-axis direction. The slide member 32 is formed in the shape of a plate extending in the X-axis direction. Since one end 32a of the slide member 32 is fixed to the movable body 31 and the other end 32b thereof comes into contact with an auxiliary rail, which is fixed to the machine base 190, with a bearing interposed therebetween, the slide member 32 is adapted to be slidable in the Y-axis direction.

The X-axis movable unit 4 includes a movable body 41 and a mounting head 42. The movable body 41 is an element of the ball screw feed mechanism to be described below, and is adapted to be slidable in the X-axis direction. The mounting head 42 is detachably mounted on the movable body 41. Although not shown, the mounting head 42 is provided with a mark camera that is formed of a CCD camera, a suction nozzle, a motor that moves up and down and rotates the suction nozzle, an air pump that generates negative pressure at the suction nozzle, a controller that controls the motor and the air pump, and various sensors. The mark camera takes an image of the component supply device 110, an image of the substrate conveying device 120, and an image of a reference mark that is formed at a predetermined position on the circuit substrate; and checks the positions of these elements. The suction nozzle sucks an electronic component supplied from the component supply device 110, and mounts the electronic component at a mounting position on the circuit substrate that is positioned by the substrate conveying device 120.

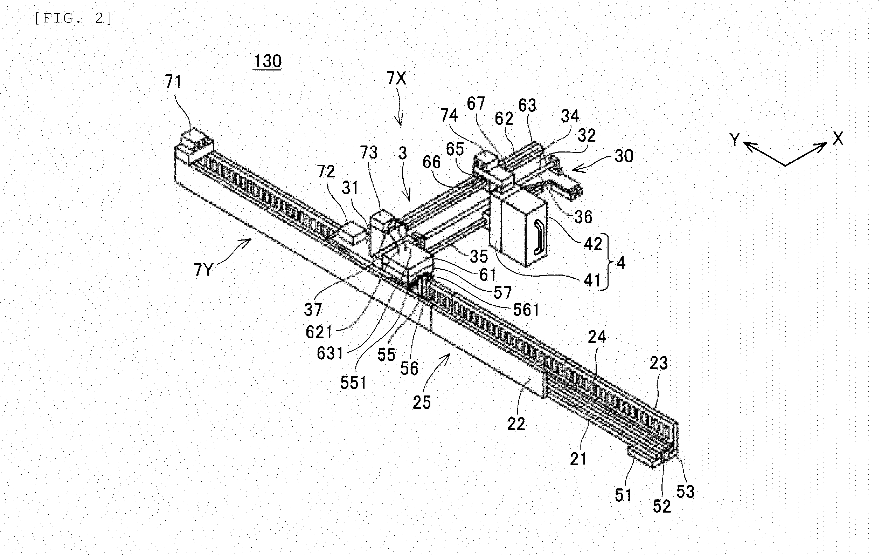

As shown in Fig. 2, the Y-axis drive device 130Y includes a linear motor mechanism 20. The linear motor mechanism 20 includes a track member 25 and the movable body 31 of the Y-axis movable unit 3. The track member 25 is fixed to the machine base 190, and extends in the Y-axis direction. The track member 25 includes a bottom wall member 21 and a pair of side wall members 22 and 23, and is formed in the shape of a groove of which an upper portion is open. The pair of side wall members 22 and 23 are raised from both side edges of the bottom wall member 21. A plurality of magnets 24 are provided in the Y-axis direction on the inner surfaces of the side wall members 22 and 23. The track member 25 corresponds to an example of a fixed section described in claims. The movable body 31 of the Y-axis movable unit 3 extends in the Y-axis direction, and a lower portion of the movable body 31 is inserted into a groove of the track member 25. Since the movable body 31 comes into contact with an upper portion of the side wall member 23, which is positioned on the side where the slide member 32 is disposed, with a bearing interposed therebetween, the movable body 31 is adapted to be slidable in the Y-axis direction.

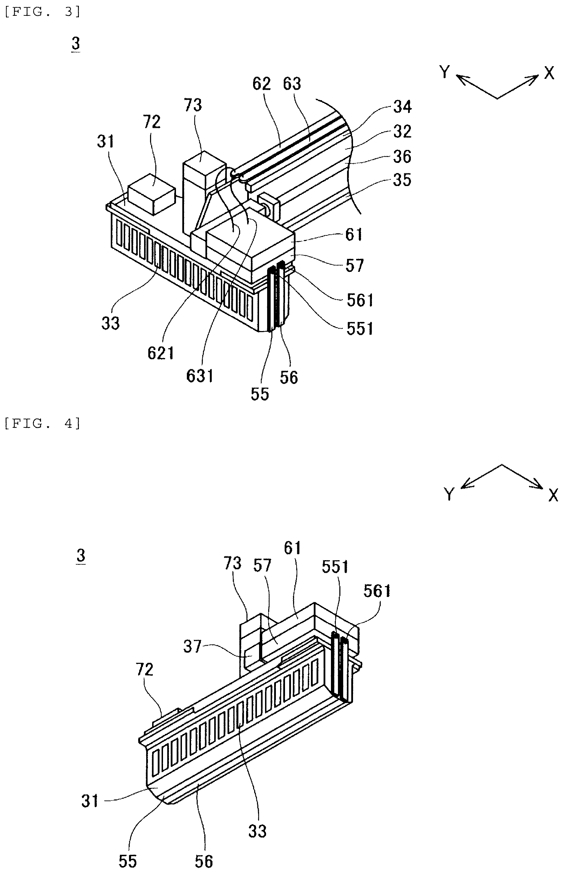

As shown in Figs. 3 and 4, a plurality of armatures 33 are provided on both side surfaces of the movable body 31. Each of the armatures 33 includes a coil and a core that is magnetized by current flowing through the coil. The armatures 33 face the magnets 24 provided on the inner surfaces of the track member 25 while the lower portion of the movable body 31 is inserted into the groove of the track member 25. The magnitude and energization time of current flowing through the coils of the armatures 33 are controlled by a controller (not shown) that is provided in the movable body 31. As described above, the linear motor mechanism 20 moves the Y-axis movable unit 3 in the Y-axis direction by using magnetic forces, which are generated between the cores of the armatures 33 provided on the movable body 31 and the magnets 24 provided on the side wall members 22 and 23 of the track member 25, as thrust.

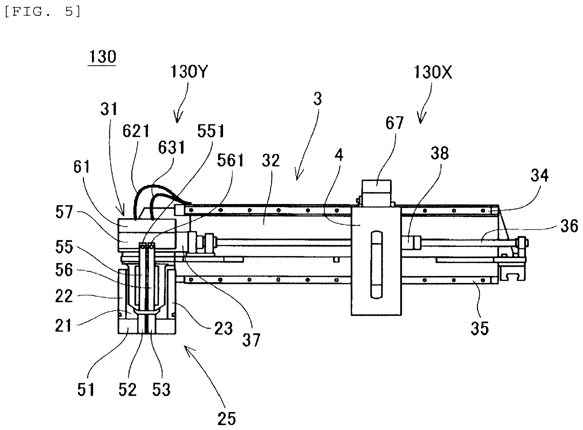

As shown in Fig. 2, the X-axis drive device 130X includes a ball screw feed mechanism 30. The ball screw feed mechanism 30 includes a pair of X-axis rails 34 and 35, a ball screw 36, a drive motor 37, a nut drive part 38 (see Fig. 5), and the movable body 41 of the X-axis movable unit 4. The pair of X-axis rails 34 and 35 are provided at upper and lower portions of a side surface of the slide member 32 of the Y-axis movable unit 3, and extend in the X-axis direction. Since the movable body 41 of the X-axis movable unit 4 comes into contact with the X-axis rails 34 and 35 with bearings interposed therebetween, the movable body 41 is adapted to be slidable in the X-axis direction. The ball screw 36 is provided between the pair of X-axis rails 34 and 35 so as to extend in the X-axis direction. Since one end of the ball screw 36 is connected to the drive motor 37, the ball screw 36 is adapted so as to be rotatable. The drive motor 37 is fixed to the movable body 31 of the Y-axis movable unit 3. The drive motor 37 is controlled by a controller (not shown) provided in the movable body 31 of the Y-axis movable unit 3, so that the rotational speed and the rotational direction of the ball screw 36 are adjusted. As shown in Fig. 5, the nut drive part 38 is fixed to the movable body 41 of the X-axis movable unit 4 and is threadably engaged with the ball screw 36. When the drive motor 37 rotationally drives the ball screw 36, the nut drive part 38 moves forward or backward. Accordingly, the X-axis movable unit 4 moves in the X-axis direction.

### (Structure of optical wireless communication system 7)

As shown in Fig. 2, an optical wireless communication system 7 includes a Y-axis optical wireless communication section 7Y that is provided in the Y-axis drive device 130Y and an X-axis optical wireless communication section 7X that is provided in the X-axis drive device 130X. The Y-axis optical wireless communication section 7Y includes a pair of optical wireless communication units 71 and 72. The X-axis optical wireless communication section 7X includes a pair of optical wireless communication units 73 and 74. Each of these optical wireless communication units 71, 72, 73, and 74 includes a laser element that transmits an optical signal and a photoelectric converting element that receives an optical signal, and is adapted to be capable of transmitting and receiving the optical signal.

The first optical wireless communication unit 71 is fixed to one end portion of the track member 25 (left rear side in Fig. 2), and the light emission surface of the laser element and the light incident surface of the photoelectric converting element are disposed so as to face the second optical wireless communication unit 72. The second optical wireless communication unit 72 is fixed to the movable body 31 of the Y-axis movable unit 3, and the light emission surface of the laser element and the light incident surface of the photoelectric converting element are disposed so as to face the first optical wireless communication unit 71. The optical axes of optical signals of the first and second optical wireless communication units 71 and 72 are parallel to the Y-axis direction.

The third optical wireless communication unit 73 is fixed to the movable body 31 of the Y-axis movable unit 3, and the light emission surface of the laser element and the light incident surface of the photoelectric converting element are disposed so as to face the fourth optical wireless communication unit 74. The fourth optical wireless communication unit 74 is fixed onto a second power receiving circuit 67 (of which the detail will be described below) fixed to the movable body 41 of the X-axis movable unit 4, and the light emission surface of the laser element and the light incident surface of the photoelectric converting element are disposed so as to face the third optical wireless communication unit 73. The optical axes of optical signals of the third and fourth optical wireless communication units 73 and 74 are parallel to the X-axis direction. Further, since the fourth optical wireless communication unit 74 and the second power receiving circuit 67 are fixed to the movable body 41 of the X-axis movable unit 4, the fourth optical wireless communication unit 74 and the second power receiving circuit 67 can be used in common even though the mounting head 42 is exchanged according to the type of production.

Optical signals, which are transmitted to the second optical wireless communication unit 72 from the first optical wireless communication unit 71, include, for example, a command signal that is transmitted to a controller controlling the armatures 33 of the linear motor mechanism 20, a command signal that is transmitted to a controller controlling the drive motor 37 of the ball screw feed mechanism 30, and a command signal that is transmitted to a controller controlling the suction nozzle provided on the X-axis movable unit 4. These command signals are converted into electrical signals from optical signals at the second optical wireless communication unit 72. Among the command signals, the command signal transmitted to the controller controlling the suction nozzle is converted into an optical signal from an electrical signal at the third optical wireless communication unit 73 and is transmitted to the fourth optical wireless communication unit 74.

Optical signals, which are transmitted to the third optical wireless communication unit 73 from the fourth optical wireless communication unit 74, include, for example, position data that are fed back from the motor moving up and down and rotating the suction nozzle and image data that are taken by the mark camera. These data are converted into electrical signals from optical signals at the third optical wireless communication unit 73, are converted into optical signals from electrical signals at the second optical wireless communication unit 72, and are transmitted to the first optical wireless communication unit 71. Further, position data, which are fed back from the linear motor mechanism 20, and position data, which are fed back from the ball screw feed mechanism 30, are also converted into optical signals from electrical signals at the second optical wireless communication unit 72, and are transmitted to the first optical wireless communication unit 71.

### (Structure of non-contact power supply unit 1)

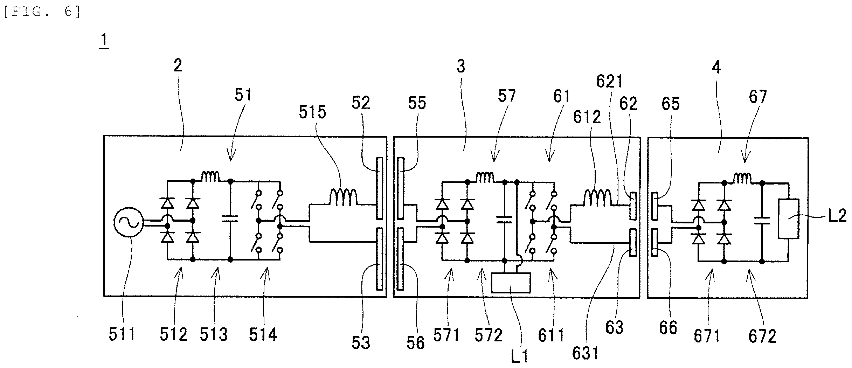

In the mounting machine 10, the supply of power is performed between the track member 25 and the Y-axis movable unit 3 and between the Y-axis movable unit 3 and the X-axis movable unit 4 by a non-contact power supply unit 1 (of which the detail is shown in Fig. 6). The non-contact power supply unit 1 provided between the track member 25 and the Y-axis movable unit 3 will be described first.

As shown in Fig. 2, the non-contact power supply unit 1 includes a high-frequency power supply circuit 51 and a pair of first power transmission electrode plates 52 and 53. The high-frequency power supply circuit 51 is provided on the lower surface of one end portion of the bottom wall member 21 of the track member 25 (right front side in Fig. 2). The high-frequency power supply circuit 51 is adapted to be capable of generating high-frequency power in the range of, for example, 100 kHz to MHz. The high-frequency power supply circuit 51 is adapted so that an output frequency and an output voltage can be adjusted. Further, the high-frequency power supply circuit 51 is adapted to be capable of generating an output voltage waveform that corresponds to a sine wave or a rectangular wave. The specific circuit configuration of the high-frequency power supply circuit 51 will be described below.

The pair of first power transmission electrode plates 52 and 53 are provided on the upper surface of the bottom wall member 21 of the track member 25. The pair of first power transmission electrode plates 52 and 53 are disposed so as to be separated from each other in the X axis direction, and extend in the Y-axis direction. Metal plates are used as the first power transmission electrode plates 52 and 53. One end portion of each of the first power transmission electrode plates 52 and 53 (the right front side in Fig. 2) is bent downward on one end face of the bottom wall member 21. Bent portions of the first power transmission electrode plates 52 and 53 are electrically connected to output terminals of the high-frequency power supply circuit 51.

As shown in Fig. 4, the non-contact power supply unit 1 further includes a pair of first power receiving electrode plates 55 and 56 and a first power receiving circuit 57. The pair of first power receiving electrode plates 55 and 56 are provided on the bottom of the movable body 31. The first power receiving electrode plates 55 and 56 are disposed so as to be separated from each other in the X-axis direction, and extend in the Y-axis direction. The first power receiving electrode plates 55 and 56 are provided almost on the entire area of the bottom of the movable body 31. Metal plates are used as the first power receiving electrode plates 55 and 56. One end portion of each of the first power receiving electrode plates 55 and 56 (the right front side in Fig. 4) is bent upward on one end face of the movable body 31. Bent portions 551 and 561 of the first power receiving electrode plates 55 and 56 are electrically connected to input terminals of the first power receiving circuit 57. The first power receiving circuit 57 is fixed onto the movable body 31. The first power receiving circuit 57 converts high-frequency power, which is received by the first power receiving electrode plates 55 and 56, and supplies the converted high-frequency power to a first electrical load L1 that is provided in the movable body 31. The specific circuit configuration of the first power receiving circuit 57 will be described below.

The pair of first power transmission electrode plates 52 and 53 and the pair of first power receiving electrode plates 55 and 56 are disposed so as to face each other and to form a pair of capacitors . Distances between the pair of first power transmission electrode plates 52 and 53 and the pair of first power receiving electrode plates 55 and 56 are maintained even though the Y-axis movable unit 3 moves in the Y-axis direction. For this reason, capacitance of the pair of capacitors is substantially constant without depending on the position of the Y-axis movable unit 3.

Next, the non-contact power supply unit 1 provided between the Y-axis movable unit 3 and the X-axis movable unit 4 will be described. As shown in Figs. 2 and 3, the non-contact power supply unit 1 includes a high-frequency power transmission circuit 61 and a pair of second power transmission electrode plates 62 and 63. The high-frequency power transmission circuit 61 is provided on the first power receiving circuit 57. Input terminals of the high-frequency power transmission circuit 61 are electrically connected to output terminals of the first power receiving circuit 57, and power is supplied to the high-frequency power transmission circuit 61 from the first power receiving circuit 57. Output terminals of the high-frequency power transmission circuit 61 are electrically connected to the pair of second power transmission electrode plates 62 and 63 through power supply lines 621 and 631. The high-frequency power transmission circuit 61 supplies high-frequency power to the pair of second power transmission electrode plates 62 and 63. The specific circuit configuration of the high-frequency power transmission circuit 61 will be described below.

The pair of second power transmission electrode plates 62 and 63 are provided on an upper surface of the slide member 32 of the Y-axis movable unit 3. The second power transmission electrode plates 62 and 63 are disposed so as to be separated from each other in the Y-axis direction, and extend in the X-axis direction. Metal plates are used as the second power transmission electrode plates 62 and 63.

The non-contact power supply unit 1 further includes a pair of second power receiving electrode plates 65 and 66 and the second power receiving circuit 67 that is fixed onto the upper surface of the X-axis movable unit 4. The pair of second power receiving electrode plates 65 and 66 are provided on the bottom of a tip portion of the second power receiving circuit 67. The second power receiving electrode plates 65 and 66 are disposed so as to be separated from each other in the Y-axis direction, and extend in the X-axis direction. Metal plates are used as the second power receiving electrode plates 65 and 66. The second power receiving electrode plates 65 and 66 are electrically connected to input terminals of the second power receiving circuit 67. The second power receiving circuit 67 is provided so as to protrude from the upper surface of the X-axis movable unit 4 to the upper side of the pair of the second power transmission electrode plates 62 and 63. The second power receiving circuit 67 converts high-frequency power, which is received by the second power receiving electrode plates 65 and 66, and supplies the converted high-frequency power to a second electrical load L2 that is provided in the X-axis movable unit 4. The specific circuit configuration of the second power receiving circuit 67 will be described below.

The pair of second power transmission electrode plates 62 and 63 and the pair of second power receiving electrode plates 65 and 66 are disposed so as to face each other and to form a pair of capacitors . Distances between the pair of second power transmission electrode plates 62 and 63 and the pair of second power receiving electrode plates 65 and 66 are maintained even though the X-axis movable unit 4 moves in the X-axis direction. For this reason, capacitance of the pair of capacitors is substantially constant without depending on the position of the X-axis movable unit 4.

### (Circuit diagram of non-contact power supply unit)

Fig. 6 shows the circuit diagram of the non-contact power supply unit 1. Here, a fixed portion that does not move relative to the machine base 190, that is, the track member 25 or the like is referred to as a fixed section 2. The high-frequency power supply circuit 51 of the fixed section 2 includes a commercial frequency power supply 511, a full-wave rectifying circuit 512, a smoothing circuit 513, a high-frequency generating circuit 514, and a tuning coil 515. The full-wave rectifying circuit 512 is formed by the bridge connection of four rectification diodes, and generates DC power, which includes pulsating flows, by performing the full-wave rectification of AC power of the commercial frequency power supply 511. The smoothing circuit 513 generates DC power, which has less variation, by smoothing the pulsating flows.

The high-frequency generating circuit 514 is formed by the bridge connection of four switching elements, and converts DC power into high-frequency power. Since the timing of the switching of the high-frequency generating circuit 514 is controlled by a high-frequency controller (not shown), an output frequency is variable. One output terminal of the high-frequency generating circuit 514 is connected to one first power transmission electrode plate 52 through the tuning coil 515. The other output terminal of the high-frequency generating circuit 514 is connected to the other first power transmission electrode plate 53. The high-frequency generating circuit 514 corresponds to an example of an AC power supply described in claims. The tuning coil 515 corresponds to an example of an inductor described in claims.

The first power receiving circuit 57 of the Y-axis movable unit 3 includes a full-wave rectifying circuit 571 and a smoothing circuit 572. The full-wave rectifying circuit 571 is formed by the bridge connection of four rectification diodes, and the input side of the full-wave rectifying circuit 571 is connected to the pair of first power receiving electrode plates 55 and 56. The full-wave rectifying circuit 571 generates DC power, which includes pulsating flows, by performing the full-wave rectification of high-frequency power that is received by the first power receiving electrode plates 55 and 56. The smoothing circuit 572 generates DC power, which has less variation, by smoothing the pulsating flows. Smoothed DC power is supplied to the first electrical load L1 and the high-frequency power transmission circuit 61. The first electrical load L1 includes the linear motor mechanism 20, the ball screw feed mechanism 30, the second optical wireless communication unit 72, and the third optical wireless communication unit 73.

The high-frequency power transmission circuit 61 includes a high-frequency generating circuit 611 in which four switching elements are bridge-connected and a tuning coil 612. The input side of the high-frequency generating circuit 611 is connected to the smoothing circuit 572, and the high-frequency generating circuit 611 converts smoothed DC power into high-frequency power. Since the timing of the switching of the high-frequency generating circuit 611 is controlled by a high-frequency controller (not shown), an output frequency is variable. One output terminal of the high-frequency generating circuit 611 is connected to one second power transmission electrode plate 62 through the tuning coil 612. The other output terminal of the high-frequency generating circuit 611 is connected to the other second power transmission electrode plate 63.

The second power receiving circuit 67 of the X-axis movable unit 4 includes a full-wave rectifying circuit 671 and a smoothing circuit 672. The full-wave rectifying circuit 671 is formed by the bridge connection of four rectification diodes, and the input side of the full-wave rectifying circuit 671 is connected to the pair of second power receiving electrode plates 65 and 66. The full-wave rectifying circuit 671 generates DC power, which includes pulsating flows, by performing the full-wave rectification of high-frequency power that is received by the second power receiving electrode plates 65 and 66. The smoothing circuit 672 generates DC power, which has less variation, by smoothing the pulsating flows. Smoothed DC power is supplied to the second electrical load L2. The second electrical load L2 includes the controller that controls the mark camera, the motor that moves up and down and rotates the suction nozzle, the air pump that generates negative pressure at the suction nozzle, the controller that controls the motor and the air pump, various sensors, and the fourth optical wireless communication unit 74.

The non-contact power supply unit 1 provided between the fixed section 2 and the Y-axis movable unit 3 includes the high-frequency power supply circuit 51, the tuning coil 515, the pair of first power transmission electrode plates 52 and 53, the pair of first power receiving electrode plates 55 and 56, and the first power receiving circuit 57. Here, the tuning coil 515 is appropriately selected so as to perform non-contact power supply using a resonant circuit, and the output frequency of the high-frequency generating circuit 514 is adjusted. Accordingly, resonant current flows between the high-frequency power supply circuit 51 and the first power receiving circuit 57, so that large power supply capacity and high power supply efficiency are obtained.

The non-contact power supply unit provided between the Y-axis movable unit 3 and the X-axis movable unit 4 includes the high-frequency power transmission circuit 61, the tuning coil 612, the pair of second power transmission electrode plates 62 and 63, the pair of second power receiving electrode plates 65 and 66, and the second power receiving circuit 67. Here, the tuning coil 612 is appropriately selected so as to perform non-contact power supply using a resonant circuit, and the output frequency of the high-frequency generating circuit 611 is adjusted. Accordingly, resonant current flows between the high-frequency power transmission circuit 61 and the second power receiving circuit 67, so that large power supply capacity and high power supply efficiency are obtained.

As described above, in the component transfer device 130 provided in the mounting machine 10, the supply of power to the Y-axis movable unit 3 from the fixed section 2 and the supply of power to the X-axis movable unit 4 from the Y-axis movable unit 3 are performed wirelessly. Moreover, the communication of command signals to the linear motor mechanism 20 and the ball screw feed mechanism 30 provided in the Y-axis movable unit 3, the communication of a command signal to the suction nozzle provided in the X-axis movable unit 4, and the communication of image data from the mark camera are also performed wirelessly. For this reason, the component transfer device 130 provided in the mounting machine 10 is not provided with a power cable and a communication cable. Accordingly, a problem of disconnection does not occur in the component transfer device 130. Further, since these cables are not present, space saving is also achieved. Moreover, in the component transfer device 130 provided in the mounting machine 10, an electric field coupling method is employed in the non-contact power supply unit 1 and an optical communication method using a laser beam is employed in the optical wireless communication system 7. Since interference caused by the electric field coupling method is suppressed in the optical communication system using a laser beam, communication having low noise can be performed. For this reason, when the optical wireless communication system 7 employing an optical communication method using a laser beam is combined with the non-contact power supply unit 1 employing an electric field coupling method, high-quality communication can be performed.

### (Multiplex communication using optical wireless communication system 7)

Data transmitted to the optical wireless communication system 7 include, for example, image data of the mark camera that is provided in the X-axis movable unit 4, operating commands that are input to the controllers for the linear motor mechanism 20 and the ball screw feed mechanism 30, servo control information that is fed back from the linear motor mechanism 20 and the ball screw feed mechanism 30, or I/O signals that are output from various sensors and switches provided in the various elements. The optical wireless communication system 7 multiplexes and transmits these data types.

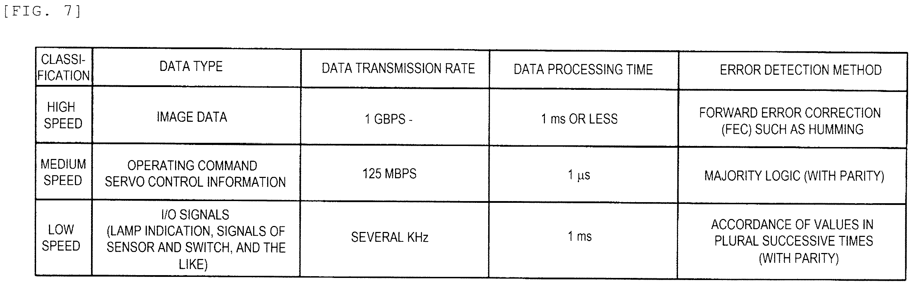

Fig. 7 is a view in which various data types subjected to multiplex communication are classified. In this example, data types are classified into three data types. Signals classified as (A) are high-speed signals, and image data taken by the mark camera are exemplified as high-speed signals. Signals classified as (B) are medium-speed signals, and an operating command of each controller and servo control information are exemplified as medium-speed signals. Signals classified as (C) are low-speed signals, and I/O signals output from various sensors and switches provided in the various elements are exemplified as low-speed signals.

The amount of image data classified as (A) is large. It is not realistic that the retransmission of data is performed against bit errors in the data type of which the amount of data is large. For this reason, the retransmission of data is not performed and the correction of an error at a receiving destination is performed. Since the amount of data is further increased when a forward error correction code (FEC) of a humming code is provided to image data, a data transmission rate of 1 GBPS or more is required. Meanwhile, since image data are not frequently updated, about 1 ms needs to be secured as a data processing time. Since the data processing time is long but a total amount of data is large in the transmission of the image data as described above, a high data transmission rate is set.

Operating commands and servo control information, which are classified as (B), are used in, for example, the servo control of the linear motor mechanism and the ball screw feed mechanism. Since an operating command needs to be generated for a motor according to the feedback of servo control information, such as torque information and position information obtained from the motor, servo control requires a high-speed response. For example, rapidity corresponding to about 1 µs is required. Meanwhile, the amount of data, which is required for the operating command and servo control information, is small. For this reason, a data transmission rate of 125 MBPS is used for the transmission of the operating command and servo control information. Further, the processing of data errors requires the reliability of a command, and processing using majority logic is performed to avoid the non-transmission of a control value. For example, the same operating command and the same servo control information to which parity codes are provided are transmitted three times. Among the three-time commands, accordance and discordance are detected by parity check. When the commands accord with each other, a weighted coefficient is provided and the grades of data values are summed up. As a result, a data value, which has the highest grade, is referred to as a definitive value. It is possible to reliably transmit a data value while ensuring reliability by transmission of data multiple times and majority logic. Further, since the processing of an error is simple, it is possible to perform high-speed processing.

The I/O signals classified as (C) are, for example, instruction signals that instruct a lamp to be turned on and off, signals that are output from sensors, and signals that are input by switches. These signals do not require rapidity, and have only to ensure, for example, a data transmission rate of several KHz and a data processing time of about 1 ms. The processing of data errors gives parity codes and is performed by transmission of data multiple times. When it is confirmed that all data have the same data value in the successive transmission, transmitted data are acquired. When there is a case in which a data value is different even only one time in the successive transmission, the transmission of data is cancelled.

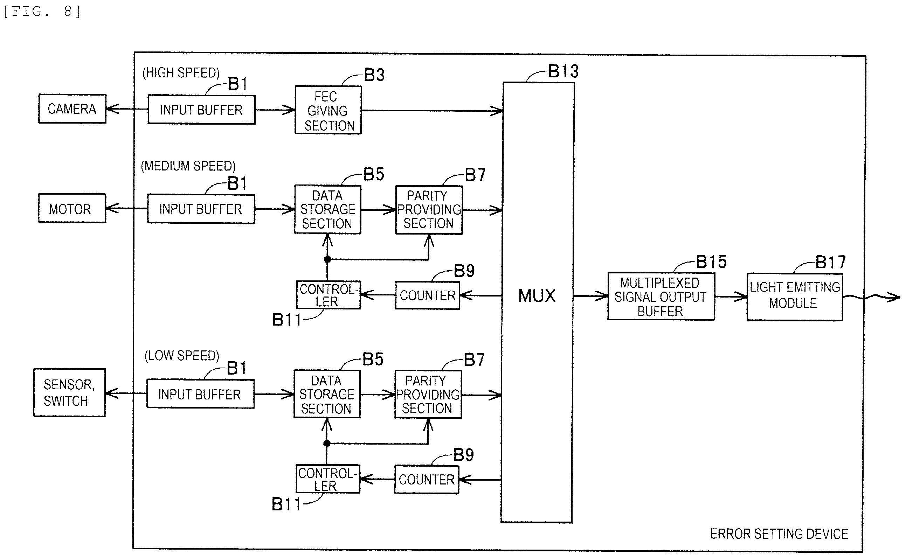

As shown in Fig. 8, image data transmitted from a camera (for example, the mark camera), servo control information transmitted from a motor (for example, the motor driving the suction nozzle), and I/O signals transmitted from the sensors or the switches are input to an input buffer B1, and error setting processing is performed for each data type.

Forward error correction codes (FEC) are calculated according to image data by an FEC providing section B3, and are provided to the image data that are input to the input buffer B1. The image data to which the FECs are provided are transmitted to a multiplexing section (MUX) B13.

The servo control information input to the input buffer B1 is stored in a data storage section B5, and parity codes are added to the servo control information at a parity providing section B7. The servo control information to which the parity codes are added is transmitted to the multiplexing section (MUX) B13. The number of times of the transmission of the servo control information to the multiplexing section (MUX) B13 is counted at a measuring instrument B9. A controller B11 controls the data storage section B5 and the parity providing section B7 according to a count value that is counted at the measuring instrument B9. Specifically, when the number of times of the transmission of the same data, which is counted as the count value, reaches a prescribed number of times that is determined in advance by majority logic, the contents of the data storage section B5 are updated. Further, until the count value reaches the prescribed number of times, parity codes are added to the servo control information stored in the data storage section B5 and are transmitted to the multiplexing section (MUX) B13 whenever data are multiplexed by the multiplexing section (MUX) B13.

The I/O signals input to the input buffer B1 are stored in the data storage section B5, and parity codes are added to the I/O signals at the parity providing section B7. The I/O signals to which the parity codes are added are transmitted to the multiplexing section (MUX) B13. The number of times of the transmission of the I/O signals to the multiplexing section (MUX) B13 is counted by the counter B9. A controller B11 controls the data storage section B5 and the parity providing section B7 according to a count value that is counted at the counter B9. Specifically, when the number of times of the transmission of the same data, which is counted as the count value, reaches a prescribed number of times that is determined in advance, the contents of the data storage section B5 are updated. Further, until the count value reaches the prescribed number of times, parity codes are added to the I/O signals stored in the data storage section B5 and are transmitted to the multiplexing section (MUX) B13 whenever data are multiplexed by the multiplexing section (MUX) B13.

The data, which are multiplexed by the multiplexing section (MUX) B13, are transmitted to a light emitting module B17 through a multiplexed signal output buffer B15, are converted into optical signals, and are sent to a transmission line. Here, the light emitting module B17 corresponds to the optical wireless communication units 71, 72, 73, and 74.

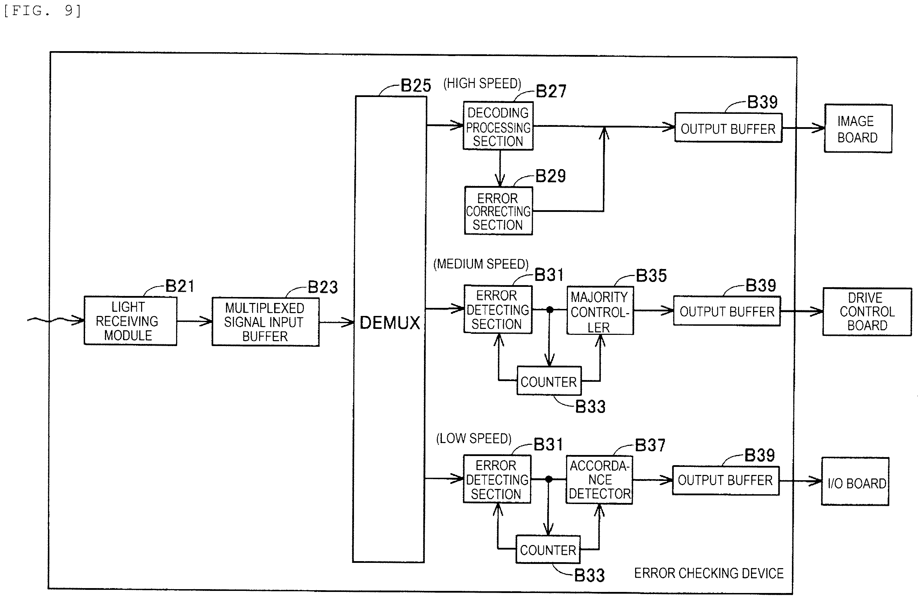

As shown in Fig. 9, the optical signals transmitted through the transmission line are received by a light receiving module B21 and are converted into electrical signals. Here, the light receiving module B21 corresponds to the optical wireless communication units 71, 72, 73, and 74. The converted electrical signals are transmitted to a multiplexed signal input buffer B23, and are demultiplexed into the respective data by a demultiplexing section (DEMUX) B25. Error detection processing or error correction processing is performed on the respective demultiplexed data according to error setting that is set for each data type.

The image data, which are high-speed data, are subjected to error detection in complex processing B27 according to the forward error correction code (FEC), and processing for processing for correcting an erroneous data value is performed in an error correcting section B29 as necessary. Corrected image data are transmitted to an image board through an output buffer B39.

The servo control information, which is medium-speed data, is subjected to parity check in an error detecting section B31. In this case, a counter B33 counts the number of times of the parity check that is performed in the error detecting section B31. Until the number of times of receiving the same data, which is counted as a count value, reaches a prescribed number of times that is determined in advance by majority logic, parity check of servo control information to be further transmitted continues to be performed. When the count value reaches the prescribed number of times, the data value of the servo control information is determined by majority logic that is determined in advance in a majority controller B35. Simultaneously, the contents of the error detecting section B31 are updated and the transmission of the next servo control information is waited for. The data value of the servo control information, which is determined by the majority logic, is transmitted to a drive control board through the output buffer B39.

The I/O signals, which are low-speed data, are subjected to parity check in the error detecting section B31. In this case, a counter B33 counts the number of times of the parity check that is performed in the error detecting section B31. Until the number of times of receiving the same data, which is counted as a count value, reaches a prescribed number of times that is determined in advance, parity check of I/O signals to be further transmitted continues to be performed. When the count value reaches the prescribed number of times, the accordance and discordance of data values of the I/O signals in the transmission of the data at the prescribed number of times are determined in an accordance detector B37. When it is determined that data values accord with each other, the data values according with each other are transmitted to an I/O board through the output buffer B39. When data values not according with each other are detected, the transmitted I/O signals are discarded together with the prescribed number of times.

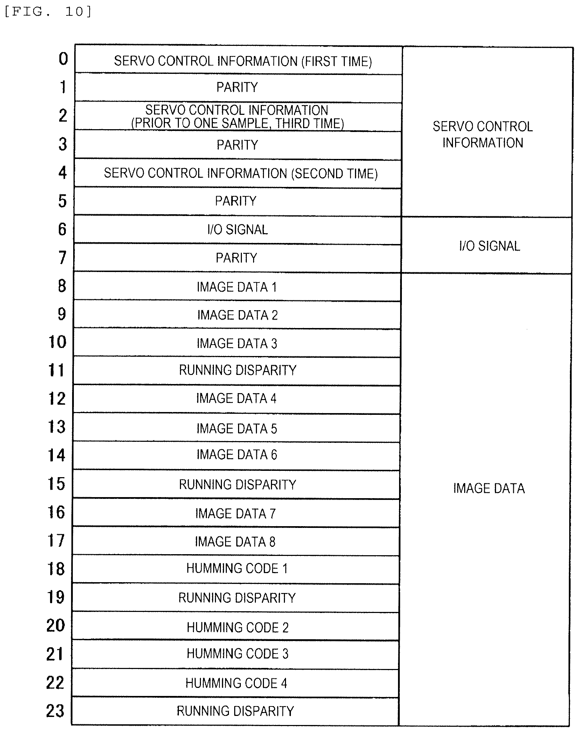

Fig. 10 shows an example of a multiplexed data column, and shows an example when three kinds of data exemplified in Fig. 7 are multiplexed. A condition is set so that one frame is 8 nsec and multiplex communication is performed at a data transmission rate of 3 GBPS. In this condition, one frame can be formed of 24 bits. Further, servo control information is transmitted three times.

According to the condition, six bits, that is, 0-th to fifth bits are ensured as a transmitted bit width of the servo control information per frame, two bits, that is, sixth and seventh bits are ensured as a transmitted bit width of the I/O signal per frame, and sixteen bits, that is, eighth to twenty-third bits are ensured as a transmitted bit width of the image data per frame.

When the number of times of transmission, which is to be repeated when servo control information of one bit is determined by majority logic, is prescribed as 3, parity bits are provided to the respective bits and a total of six bits are required. Since 6 bit widths are ensured per one frame, a bit width for transmitting servo control information of 1 bit is ensured for each frame. Here, since a condition that one frame is 8 nsec is set, a data transmission rate required for servo control information corresponds to 125 MBPS (see Fig. 7). According to the frame condition exemplified in Fig. 10, the transmission of 1-bit servo control information can be performed by the majority logic of three times of transmission.

In this case, servo control information of the second bit corresponds to the third transmission for the servo control information prior to one sample. It is possible to reduce a probability, which is affected by a burst error, and to reliably transmit data by changing a frame to be transmitted to another frame in at least one time of transmission among three times of transmission.

Further, as for the image data, among bit widths of sixteen bits, that is, eighth to twenty-third bits, 8 bits of image data are transmitted. The remaining 4 bits are humming codes. Furthermore, the remaining 4 bits are bits of running disparity.

A cycle per one frame is 8 nsec (frequency is 125 MHz) . Accordingly, when image data of 8 bits are transmitted per one frame, "8×125M=1G bits" is satisfied in a unit time and corresponds to the data transmission rate of the image data exemplified in Fig. 7.

Here, the running disparity is a technique that inserts an inverted bit value between bit strings in which the same bit values continue. The inverted bit value is inserted to synchronize multiplexed data columns that are to be transmitted to a receiving side.

The example of the frame of Fig. 10 is an example that can satisfy the specifications of a data transmission rate of 1 GBPS in a condition where the insertion of running disparity of 4 bits and humming codes of 4 bits is allowed.

Meanwhile, since a data transmission rate of the I/O signal is low in comparison with the conditions of the frame forming the multiplexed data column, it is possible to sufficiently cope with the I/O signal by ensuring a 2-bit width.

As described above, in the multiplex communication using the optical wireless communication system 7, image data, servo control information, and I/O signals having data transmission rates and data processing times different from each other are classified into different data types, and error setting corresponding to the data types is performed. As a result, multiplex communication is performed. For this reason, error detection processing or error correction processing can be individually performed on the receiving side.

In this case, since error processing is not performed on the entire multiplexed data columns, processing for checking errors, which is performed on the entire multiplexed data columns on the receiving side, is not necessary. Since it is possible to perform processing for checking errors corresponding to the data types, it is possible to optimize the time, which is required for the detection and correction of errors, according to the data types.

Embodiments of the invention have been described in detail above, but these embodiments are merely illustrative and do not limit claims. Various modifications and alterations of the above-mentioned embodiments fall within the scope of the invention, which is defined by the claims.

### Reference Signs List

3: Y-axis movable unit
4: X-axis movable unit
20: linear motor mechanism
30: ball screw feed mechanism
31: movable body
32: slide member
51: high-frequency power supply circuit
52, 53: first power transmission electrode plate
55, 56: first power receiving electrode plate
57: first power receiving circuit
61: high-frequency power transmission circuit
62, 63: second power transmission electrode plate
65, 66: second power receiving electrode plate
67: second power receiving circuit
130, 140: component transfer device
71, 72, 73, 74: optical wireless communication unit

## Claims

1. A drive device (130) comprising:
a fixed section;
a first optical wireless communication unit (71) that is provided in the fixed section;
a first movable unit (3) that is adapted to be movable relative to the fixed section in a first direction;
a second optical wireless communication unit (72) that is provided in the first movable unit (3) and is adapted to wirelessly communicate with the first optical wireless communication unit (71);
a non-contact power supply unit (1) that supplies power to a power receiving unit (57) provided in the first movable unit (3) from a power transmission unit (51) provided in the fixed section in a non-contact manner;
a second movable unit (4) that is provided in the first movable unit (3) and is adapted to be movable relative to the first movable unit (3) in a second direction different from the first direction; and
a fourth optical wireless communication unit (74) that is provided in the second movable unit (4),
wherein an optical axis of an optical signal between the first optical wireless communication unit (71) and the second optical wireless communication unit (72) is parallel to the first direction,
**characterized by**
a third optical wireless communication unit (73) that is provided in the first movable unit (3) and is connected to the second optical wireless communication unit (72), wherein an optical axis of an optical signal between the third optical wireless communication unit (73) and the fourth optical wireless communication unit (74) is parallel to the second direction,
the power transmission unit (51) of the non-contact power supply unit (1) includes a pair of power transmission electrodes (52, 53), an inductor (515) that is electrically connected to the pair of power transmission electrodes (52, 53), and an AC power supply (511) that supplies AC power to the pair of power transmission electrodes (52, 53),
the power receiving unit (57) of the non-contact power supply unit (1) includes a pair of power receiving electrodes (55, 56) that face the pair of power transmission electrodes (52, 53), respectively,
the non-contact power supply unit (1) supplies the power to the power receiving unit (57) from the power transmission unit (51) using an electric field coupling method, and
the first optical communication unit (71) and the second optical communication unit (72) are adapted to multiplex a plurality of pieces of data and to communicate with each other.

2. The drive device (130) according to claim 1, further comprising:
a linear motor mechanism (20) that drives the first movable unit (3) in the first direction.

3. The drive device (130) according to claim 1 or 2,
wherein the first optical wireless communication unit (71) and the second optical wireless communication unit (72) are adapted to interactively communicate with each other.

4. The drive device (130) according to any one of claims 1 to 3, further comprising:
a motor (37) that is provided in the first movable unit (3) and drives the second movable unit (4); and
a controller that is provided in the first movable unit (3) and controls the motor (37),
wherein the controller drives the motor (37) on the basis of a command signal that is transmitted to the second optical wireless communication unit (72) from the first optical wireless communication unit (71).

5. A substrate work machine (10) comprising:
the drive device (130) according to any one of claims 1 to 4.

## Patentansprüche

1. Antriebsvorrichtung (130), die umfasst:
einen stationären Abschnitt;
eine erste Einheit (71) für drahtlose optische Kommunikation, die in dem stationären Abschnitt vorhanden ist;
eine erste bewegliche Einheit (3), die so eingerichtet ist, dass sie relativ zu dem stationären Abschnitt in einer ersten Richtung bewegt werden kann;
eine zweite Einheit (72) für drahtlose optische Kommunikation, die in der ersten beweglichen Einheit (3) vorhanden und so eingerichtet ist, dass sie drahtlos mit der ersten Einheit (71) für drahtlose optische Kommunikation kommuniziert;
eine Einheit (1) für kontaktlose Energiezufuhr, die einer Energieempfangs-Einheit (57), die in der ersten beweglichen Einheit (3) vorhanden ist, kontaktlos Energie von einer Energiesende-Einheit (51) zuführt, die in dem stationären Abschnitt vorhanden ist;
eine zweite bewegliche Einheit (4), die in der ersten beweglichen Einheit (3) vorhanden und so eingerichtet ist, dass sie relativ zu der ersten beweglichen Einheit (3) in einer zweiten Richtung bewegt werden kann, die sich von der ersten Richtung unterscheidet; und
eine vierte Einheit (74) für drahtlose optische Kommunikation, die in der zweiten beweglichen Einheit (4) vorhanden ist,
wobei eine optische Achse eines optischen Signals zwischen der ersten Einheit (71) für drahtlose optische Kommunikation und der zweiten Einheit (72) für drahtlose optische Kommunikation parallel zu der ersten Richtung ist,
**gekennzeichnet durch**
eine dritte Einheit (73) für drahtlose optische Kommunikation, die in der ersten beweglichen Einheit (3) vorhanden und mit der zweiten Einheit (72) für drahtlose optische Kommunikation verbunden ist, wobei eine optische Achse eines optischen Signals zwischen der dritten Einheit (73) für drahtlose optische Kommunikation und der vierten Einheit (74) für drahtlose optische Kommunikation parallel zu der zweiten Richtung ist,
die Energiesende-Einheit (51) der Einheit (1) für kontaktlose Energiezufuhr ein Paar Energiesende-Elektroden (52, 53), einen Induktor (515), der elektrisch mit den paarigen Energiesende-Elektroden (52, 53) verbunden ist, und eine Wechselstromquelle (511) umfasst, die den paarigen Energiesende-Elektroden (52, 53) Wechselstrom zuführt,
die Energieempfangs-Einheit (57) der Einheit (1) für kontaktlose Energiezufuhr ein Paar Energieempfangs-Elektroden (55, 56) enthält, die jeweils den paarigen Energiesende-Elektroden (52, 53) gegenüberliegen,
die Einheit (1) für kontaktlose Energiezufuhr die Energie von der Energiesende-Einheit (51) der Energieempfangs-Einheit (57) unter Einsatz eines elektrischen Feldkopplungs-Verfahrens zuführt, und
die erste Einheit (71) für drahtlose optische Kommunikation sowie die zweite Einheit (72) für drahtlose optische Kommunikation so eingerichtet sind, dass sie eine Vielzahl von Datenelementen gleichzeitig übertragen und miteinander kommunizieren.

2. Antriebsvorrichtung (130) nach Anspruch 1, des Weiteren umfassend:
einen Linearmotor-Mechanismus (20), der die erste bewegliche Einheit (3) in der ersten Richtung antreibt.

3. Antriebsvorrichtung (130) nach Anspruch 1 oder 2,
wobei die erste Einheit (71) für drahtlose optische Kommunikation und die zweite Einheit (72) für drahtlose optische Kommunikation so eingerichtet sind, dass sie interaktiv miteinander kommunizieren.

4. Antriebsvorrichtung (130) nach einem der Ansprüche 1 bis 3, die des Weiteren umfasst:
einen Motor (37), der in der ersten beweglichen Einheit (3) vorhanden ist und die zweite bewegliche Einheit (4) antreibt; sowie
eine Steuerungseinrichtung, die in der ersten beweglichen Einheit (3) vorhanden ist und den Motor (37) steuert,
wobei die Steuerungseinrichtung den Motor (37) auf Basis eines Befehlssignals steuert, das von der ersten Einheit (71) für drahtlose optische Kommunikation zu der zweiten Einheit (72) für drahtlose optische Kommunikation übertragen wird.

5. Substrat-Bearbeitungsmaschine (10), die umfasst:
die Antriebsvorrichtung (130) nach einem der Ansprüche 1 bis 4.

## Revendications

1. Dispositif d'entraînement (130) comprenant :
une section fixe,
une première unité de communication optique sans fil (71) qui est disposée dans la section fixe,
une première unité mobile (3) qui est conçue pour être mobile par rapport à la section fixe dans une première direction,
une deuxième unité de communication optique sans fil (72) qui est disposée dans la première unité mobile (3) et qui est conçue pour communiquer sans fil avec la première unité de communication optique sans fil (71),
une unité d'alimentation sans contact (1) qui fournit de l'énergie à une unité de réception d'énergie (57) disposée dans la première unité mobile (3) à partir d'une unité de transmission d'énergie (51) disposée sans contact dans la section fixe,
une seconde unité mobile (4) qui est disposée dans la première unité mobile (3) et qui est conçue pour pouvoir se déplacer par rapport à la première unité mobile (3) dans une seconde direction différente de la première direction, et
une quatrième unité de communication optique sans fil (74) qui est disposée dans la seconde unité mobile (4),
dans lequel l'axe optique d'un signal optique entre la première unité de communication optique sans fil (71) et la deuxième unité de communication optique sans fil (72) est parallèle à la première direction,
**caractérisé par** :
une troisième unité de communication optique sans fil (73) qui est disposée dans la première unité mobile (3) et qui est reliée à la deuxième unité de communication optique sans fil (72),
dans lequel l'axe optique d'un signal optique entre la troisième unité de communication optique sans fil (73) et la quatrième unité de communication optique sans fil (74) est parallèle à la seconde direction,
l'unité de transmission d'énergie (51) de l'unité d'alimentation sans contact (1) inclut une paire d'électrodes de transmission d'énergie (52, 53), une bobine d'inductance (515) qui est reliée électriquement à la paire d'électrodes de transmission d'énergie (52, 53), et une alimentation alternative (511) qui fournit de l'énergie alternative à la paire d'électrodes de transmission d'énergie (52, 53),
l'unité de réception d'énergie (57) de l'unité d'alimentation sans contact (1) inclut une paire d'électrodes de réception d'énergie (55, 56) qui font respectivement face à la paire d'électrodes de transmission d'énergie (52, 53),
l'unité d'alimentation sans contact (1) fournit l'énergie à l'unité de réception d'énergie (57) à partir de l'unité de transmission d'énergie (51) en utilisant un procédé de couplage par champ électrique, et
la première unité de communication optique (71) et la deuxième unité de communication optique (72) sont conçues pour multiplexer une pluralité d'éléments de données et pour communiquer l'une avec l'autre.

2. Dispositif d'entraînement (130) selon la revendication 1, comprenant en outre :
un mécanisme de moteur linéaire (100) qui entraîne la première unité mobile (3) dans la première direction.

3. Dispositif d'entraînement (130) selon la revendication 1 ou la revendication 2,
dans lequel la première unité de communication optique sans fil (71) et la deuxième unité de communication optique sans fil (72) sont conçues pour communiquer interactivement l'une avec l'autre.

4. Dispositif d'entraînement (130) selon l'une quelconque des revendications 1 à 3, comprenant en outre :
un moteur (37) qui est disposé dans la première unité mobile (3) et qui entraîne la seconde unité mobile (4), et
un contrôleur qui est disposé dans la première unité mobile (3) et qui pilote le moteur (37),
dans lequel le contrôleur attaque le moteur (37) sur la base d'un signal de commande qui est transmis à la deuxième unité de communication optique sans fil (72) depuis la première unité de communication optique sans fil (71).

5. Machine d'usinage de substrats (10) comprenant :
le dispositif d'entraînement (130) conforme à l'une quelconque des revendications 1 à 4.
